Europäisches Patentamt

European Patent Office

Office européen des brevets

(11) Publication number: **0 355 979**
**A2**

# EUROPEAN PATENT APPLICATION

(21) Application number: **89307190.2**

(22) Date of filing: **14.07.89**

(51) Int. Cl.4: **H03F 3/60 , H03H 7/48 , H04B 7/185**

(30) Priority: **17.08.88 GB 8819502**

(43) Date of publication of application:
**28.02.90 Bulletin 90/09**

(84) Designated Contracting States:
**DE ES FR GB IT NL**

(71) Applicant: **BRITISH AEROSPACE PUBLIC LIMITED COMPANY**
**11 Strand**
**London WC2N 5JT(GB)**

(72) Inventor: **Lockwood, Andrew S.**
**British Aerospace(Space Systems)Limited**
**Argyle Way**
**Stevenage Herts SG1 2AS(GB)**

(74) Representative: **Rooney, Paul Blaise et al**
**British Aerospace plc Corporate Patents**
**Department Brooklands Road**
**Weybridge Surrey KT13 0SJ(GB)**

(54) **Power amplifying assembly.**

(57) A power amplifying assembly has input ports (1 to 16) and output ports (1a to 16a) connected by a network (18) of balanced amplifier devices (17) which operate to couple the input ports to the output ports so that any amplification of a signal received at one of the input ports is shared by all the amplifier devices (17). This allows the total available amplification power to be used by any one or a combination of the output ports (1a to 16a) making the assembly particularly useful in a communications satellite with an antenna arrangement supplying signals to the input ports.

EP 0 355 979 A2

## POWER AMPLIFYING ASSEMBLY

This invention relates to a power amplifying assembly particularly, but not exclusively, for use within a spacecraft such as a communications satellite.

The need has arisen to design communications satellites with increasing amounts of traffic flexibility. This has been brought about by the trend towards large numbers of satellite antenna beams (and hence coverage areas). This trend can be accounted for as follows:

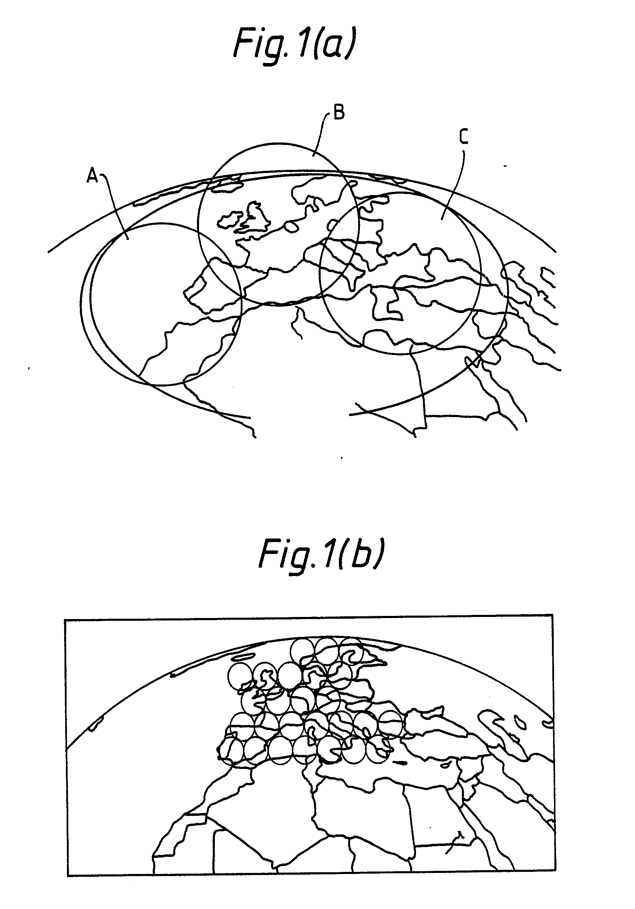

1. Conventionally, satellites have generated large coverage areas on the Earth's surface using relatively small antennas on the satellite, due to limitations in the satellite technology. In order to increase the satellite's effective output power (EIRP - Effective Isotropic Radiated Power) and input sensitivity (G/T - Gain to noise temperature ratio) the satellite antenna gain can be increased resulting in a smaller beam. Many such beams are then used to provide the same total coverage of the Earth's surface as the original large beam. Figure 1(a) and (b) shows examples of this conventional technique of multiple beam coverage.

2. The first generations of operational communications satellites were designed and used for international communications and essentially required almost global coverage. More recently, communications satellites have been employed by individual countries, or relatively small groups of countries, to provide domestic or intra-regional communications. Smaller coverage areas are needed for these applications. However, the financial viability of domestic communications satellites is being called into question and there is now a tendency to 'pool' the resources of a communications satellite between several countries, with the ability to 'reconfigure' the resources within the satellite to serve one or other of the countries at different times during the satellite's lifetime. This gives rise to the need for many separate antenna beams, with an uncertain allocation of satellite resources (bandwidth and power) between those beams.

Another trend, linked to the above use of many smaller antenna beams, is for communications satellites to be larger and to carry large numbers of transponders (up to fifty). This results in the need to be able flexibly to connect (switch, etc) up to fifty transponders between, say, twenty to forty antenna beams.

Satellite lifetimes have evolved over the last twenty years from two to three years to ten to fifteen years. The ability accurately to predict the exact traffic requirements this far in advance (plus the three year satellite construction period) is becoming a major problem.

Two further relevant factors are as follows:

1. The trend towards using small Earth stations is the result of trading-off the relative costs of the satellite and the Earth stations in a total system. To make the Earth station smaller and less expensive and so to allow such Earth stations to proliferate, involves less efficient use of the satellite resource. In particular, this means using more satellite power per link than would be necessary for operation with a larger Earth station. This inevitably means that the satellite 'transponder' is operating in a 'power limited' mode and actually has more bandwidth available than it can usefully use.

2. Small and cheap Earth stations also encourage the use of SCPC (Single Channel Per Carrier) mode of operation which means that there are many carriers simultaneously present within the same satellite transponder bandwidth. Each carrier will support its group of Earth stations. To avoid intermodulation distortion dominating the performance of the links the satellite HPA (High Power Amplifier) has to be operated in a linear mode, commonly called "backed-off".

In the past, payloads for communications satellites have tended to comprise a number of fixed power, fixed traffic capacity transponders which are directed to required coverage beam. Clearly in view of the factors mentioned hereinbefore, a more flexible reconfigurable arrangement is required. It has been proposed that this should be achieved by the use of switching networks between high power amplifiers of the satellite payload and transmit antenna beam ports. However this would result in the satellite capability being severely limited by the mass, size, complexity and power loss of the switching networks that must be included.

Thus one object of the present invention is to provide a power amplifying assembly capable of ensuring improved flexibility of operation. Preferably the power amplifying assembly has improved operating flexibility without the severe capability limitations associated with the previous proposal.

This makes it possible to provide a communications satellite in which the payload may be considered as a single resource of power and with traffic capacity which can be shared between coverage beams in any required distribution.

According to one aspect of the present invention there is provided a power amplifying assembly, characterised by including a plurality of input ports for receiving signals, a plurality of output ports and a network of balanced amplifier devices operable to couple the input ports to the output ports in a manner such that any amplification of a signal received at any one of the input ports is shared by all the amplifier devices to allow the total available amplification power to be used by any one or a combination of output ports.

Preferably the effective amplifying power of the network is the sum of the amplifying powers of the individual amplifier devices.

Conveniently each amplifier device is a balanced amplifier in which two input ports are coupled via a first 90° hybrid coupler to two amplifier means whose outputs are coupled via a second 90° hybrid coupler to two output ports, so that a signal supplied to one input port will be transmitted to the diagonally opposite output port.

Advantageously the network comprises a plurality of balanced amplifiers having a nested configuration wherein additional 90° hybrid couplers are provided between the input ports and the first couplers and between the second couplers and the output ports.

According to a further aspect of the present invention there is provided a spacecraft, preferably a communications satellite, including a power amplifying assembly as hereinbefore described.

For a better understanding of the present invention, and to show how the same may be carried into effect, reference will now be made, by way of example, to the accompanying drawings, in which:-

Figure 1(a) is a schematic view of a conventional technique of multiple beam coverage showing the use of three spot beams A, B and C,

Figure 1(b) is a view of a conventional technique similar to that of Figure 1(a) but to a smaller scale and using more spot beams,

Figure 2 is a block diagram showing a general form of shared power amplification module (called herein a SPAM) forming part of a power amplifying assembly according to one embodiment of the invention,

Figure 3 is a diagram of a balanced amplifier device forming part of a power amplifying assembly of the present invention,

Figure 4(a) is a schematic diagram of a nested balanced amplifier device for use in an assembly of the present invention,

Figure 4(b) is a specific configuration of the device of Figure 4(a),

Figure 5 is a view similar to that of Figure 4-(b) showing an 8 port 8 stage SPAM network,

Figure 6 is a view similar to that of Figure 5 showing a 4 port 8 stage SPAM network, and

Figure 7 is a view similar to that of Figures 5 and 6 but showing a 16 port 16 stage SPAM network.

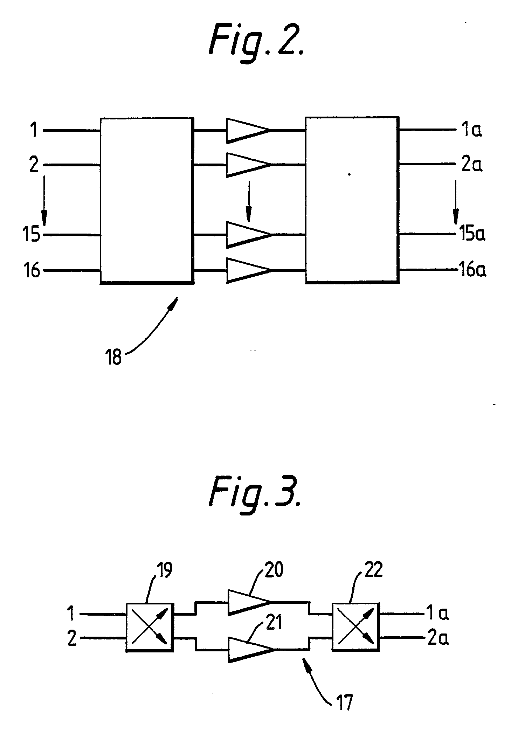

In the invention, a plurality of input ports 1 to 16, which receive signals from a satellite antenna arrangement (not shown) are coupled to a plurality of output ports 1a to 16a via a network of balanced amplifier devices 17 such that any amplification of the received signals is shared by the amplifier devices 17. The network 18, or shared power amplification module (SPAM) effectively comprises a number, perhaps a quite large number of amplifiers 17 connected in such a way that they act as a single amplifier with more than one input and output. The effective power of the SPAM is the sum of the powers of the individual devices. This is shown schematically in Figure 2. The network 18 of balanced amplifier devices 17 is operable to couple the input ports 1 to 16 to the output ports 1a to 16a so that any amplification of a signal received at any one of the input ports is shared by all the amplifier devices 17 to allow the total available amplification power to be used by any one or a combination of output ports.

The SPAM is based around the balanced amplifier device 17, as shown in Figure 3. In this illustrated device 17 a first 90° hybrid coupler 19, preferably a 3dB coupler, couples the input ports 1,2 two two amplifier means 20,21 whose outputs are coupled via a second 90° hybrid coupler 22, preferably also a 3dB coupler, to the output ports 1a, 2a, so that a signal supplied to one input port 1 will be transmitted to the diagonally opposite output port 2a. Both input ports can be used simultaneously. The total output power will be the sum of the individual amplifier 20,21 output powers (minus a small amount due to hybrid loss). The distribution of this power at the outputs 1a,2a is proportional to the power distribution at the inputs 1,2.

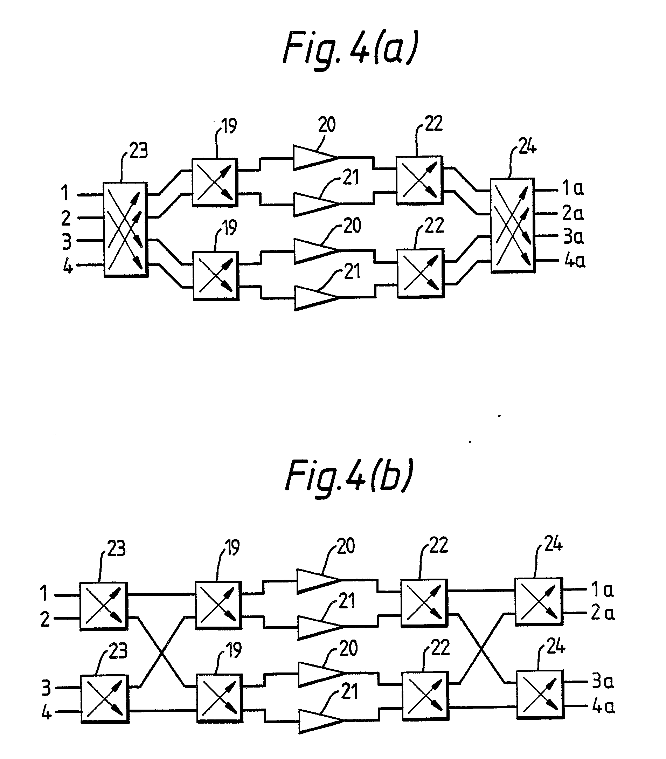

The number of inputs and outputs and the SPAM total power can be increased by nesting balanced amplifiers within each other, as shown in Figures 4a and 4b, which illustrate 4 port 4 stage networks. To this end, additional 90° hybrid couplers 23 and 24, also preferably 3dB couplers are provided between the input ports 1 to 16 and the first couplers 19 and between the second couplers 22 and the output ports 1a to 16a.

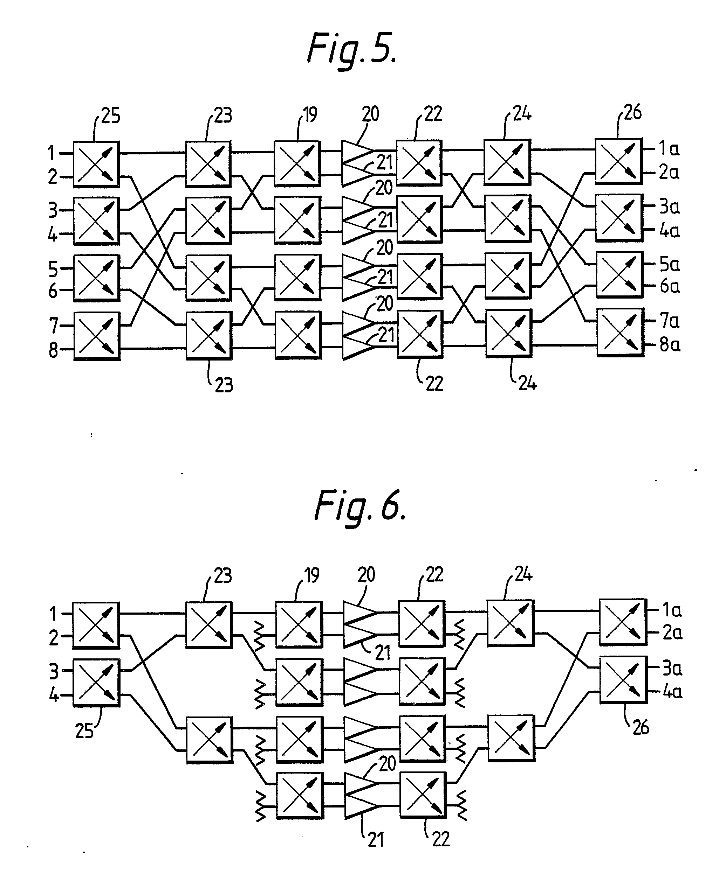

The network can be extended further, in a similar manner, to achieve a SPAM with as many ports or amplifiers as required. An eight port 8 stage assembly is shown in Figure 5 utilising additional 90° hybrid couplers 25,26.

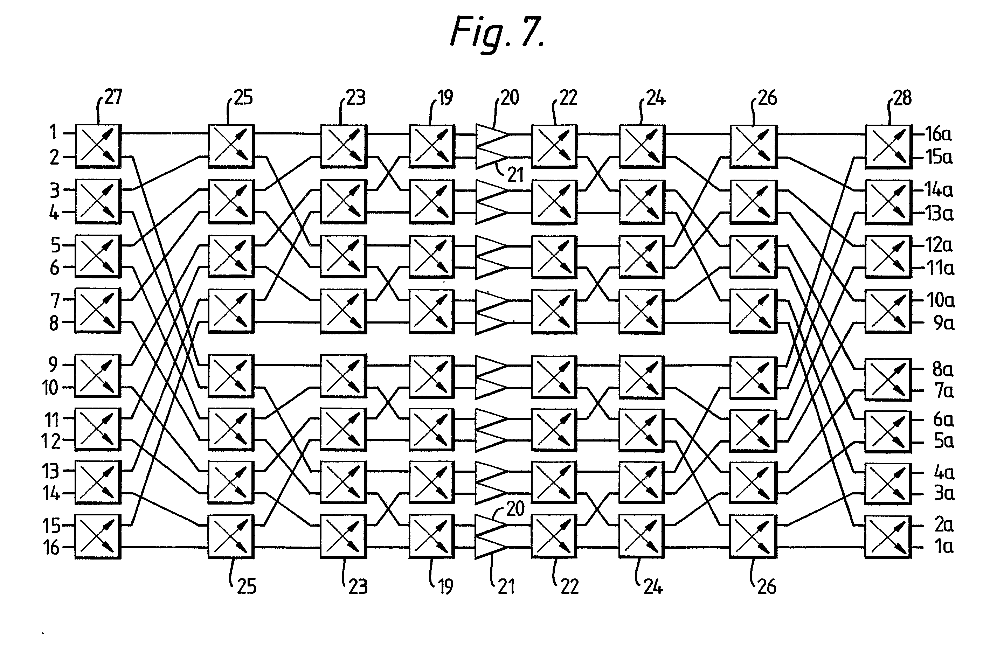

If more amplifiers than ports are required, then the network can be 'pruned' by removing unused hybrid couplers as required. Figure 6 shows a four-port, eight amplifier SPAM network, while Figure 7 shows a 16 stage network incorporating additional hybrid couplers 27 and 28.

**Claims**

1. A power amplifying assembly, characterised by including a plurality of input ports (1 to 16) for receiving signals, a plurality of output ports (1a to 16a) and a network (18) of balanced amplifier devices (17) operable to couple the input ports (1 to 16) to the output ports (1a to 16a) in a manner such that any amplification of a signal received at any one of the input ports (1 to 16) is shared by all the amplifier devices (17) to allow the total available amplification power to be used by any one or a combination of output ports (1a to 16a).

2. An assembly according to claim 1, wherein the effective amplifying power of the network (18) is the sum of the amplifying powers of the individual amplifier devices (17).

3. An assembly according to claim 1 or claim 2, wherein each amplifier device (17) is a balanced amplifier in which two input ports (1,2) are coupled via a first 90° hybrid coupler (19) to two amplifier means (20,21) whose outputs are coupled via a second 90° hybrid coupler (22) to two output ports (1a,2a), so that a signal supplied to one input port (1) will be transmitted to the diagonally opposite output port (2a).

4. An assembly according to claim 3, in which the network (18) comprises a plurality of balanced amplifiers (17) having a nested configuration wherein additional 90° hybrid couplers (23,24,25,26,27,28) are provided between the input ports (1 to 16) and the first couplers (19) and between the second couplers (22) and the output ports (1a to 16a).

5. A spacecraft including a power amplifying assembly according to any one of claims 1 to 4.

6. A spacecraft according to claim 5, in the form of a communications satellite including an antenna arrangement operable to supply signals to the input ports.

## Fig.1(a)

## Fig.1(b)

# Fig.2.

# Fig.3.

## Fig. 4(a)

## Fig.4(b)

## Fig. 5.

## Fig. 6.

Fig. 7.